# EUROPÄISCHE PATENTSCHRIFT

(11) **EP 1 371 273 B1**
(45) Veröffentlichungstag und Bekanntmachung des Hinweises auf die Patenterteilung: **04.08.2004**
(21) Anmeldenummer: 02711867.8
(22) Anmeldetag: 14.02.2002
(51) Int. Cl.: H05K 1/11, H05K 3/36

(54) **VERBUND AUS FLÄCHIGEN LEITERELEMENTEN**
LAMINATE COMPRISED OF FLAT CONDUCTOR ELEMENTS
COMPOSITE FORME D'ELEMENTS CONDUCTEURS PLATS

(30) Priorität: 09.03.2001 DE 10111389
(43) Veröffentlichungstag der Anmeldung: 17.12.2003
(73) Patentinhaber: Dr. Johannes Heidenhain GmbH, 83292 Traunreut (DE)
(72) Erfinder: RISSING, Lutz, 83358 Seebruck (DE); FISCHER, Peter, 83253 Rimsting (DE)
(86) Internationale Anmeldenummer: PCT/EP2002/001590
(87) Internationale Veröffentlichungsnummer: WO 2002/076159

(56) Entgegenhaltungen:
- EP-A- 0 696 159
- DE-U- 29 517 067
- PATENT ABSTRACTS OF JAPAN vol. 015, no. 084 (P-1172), 27. Februar 1991 (1991-02-27) -& JP 02 301725 A (HITACHI DEVICE ENG CO LTD), 13. Dezember 1990 (1990-12-13)
- PATENT ABSTRACTS OF JAPAN vol. 018, no. 375 (E-1578), 14. Juli 1994 (1994-07-14) -& JP 06 104547 A (CANON INC), 15. April 1994 (1994-04-15)
- PATENT ABSTRACTS OF JAPAN vol. 010, no. 106 (P-449), 22. April 1986 (1986-04-22) & JP 60 238714 A (HITACHI SEISAKUSHO KK), 27. November 1985 (1985-11-27)
- PATENT ABSTRACTS OF JAPAN vol. 1996, no. 05, 31. Mai 1996 (1996-05-31) -& JP 08 023148 A (NIPPONDENSO CO LTD), 23. Januar 1996 (1996-01-23)

## Beschreibung

Die Erfindung betrifft einen Verbund aus flächigen Leiterelementen mit Lotausweichbereichen. Ebenso bezieht sich die Erfindung auf die Verwendung dieses Verbundes in Sensorelementen.

Die Verbindung von flächigen Leiterelementen, z. B. von Leiterplatten beziehungsweise Leiterfolien, wird in vielen Bereichen der Elektronik in großen Stückzahlen eingesetzt. Insbesondere bei Sensorelementen muss nicht selten durch einen derartigen Verbund der eigentliche Sensor an die Auswerteelektronik angebunden werden. Dabei sind oft die Sensorstrukturen als Leiterbahnen auf Leiterplatten, die beispielsweise aus Glas sein können, ausgebildet. Der Anschluss zur Auswerteelektronik erfolgt dann häufig über Leiterbahnen auf einer flexiblen Leiterbahnfolie. Die Leiterplatte und die Leiterbahnfolie werden üblicherweise mit einem Kontaktlötverfahren, insbesondere mit dem Bügellötverfahren, derart verbunden, dass die entsprechenden Leiterbahnen in elektrischem Kontakt zueinander stehen.

Verfahren zum Löten von zwei flächigen Leiterelementen sind aus JP-A-02 301 725 und JP-A-06 104 547 bekannt.

Um den Bestrebungen zur Miniaturisierung im Elektronikbereich Rechnung zu tragen, werden die Leiterbahnen, bzw. die sogenannten Lötpads, in immer engeren Abstandsmaßen zueinander angeordnet. Lötpads sind die Bereiche, innerhalb welchen die Kontaktflächen der Leiterbahnen der jeweiligen Lötpartner angeordnet sind. Zur Kontaktierung von Leiterbahnen, die auf zwei flächigen Leiterplatten, bzw. Leiterfolien angeordnet sind, wird, wie bereits oben erwähnt, häufig das Bügellötverfahren angewendet. Auf zumindest einem der beiden Lötpartner wird dabei auf einem Lötpad ein Lotdepot aufgetragen, wobei das Volumen des Lotdepots, also die Lotmenge, naturgemäß nur mit begrenzter Genauigkeit im Rahmen bestimmter Toleranzgrößen aufgebracht werden kann. Selbst bei einem galvanisch aufgebrachtem Lotdepot kann das wirkliche Volumen des Lötdepots um bis zu 50% schwanken.

Je nach Anwendungsfall und technischer Realisierbarkeit wird häufig das Lotdepot nur auf einem der Lötpartner vorgesehen. Um eine hochwertige Lötverbindung zu erreichen, ist das Volumen des Lotdepots möglichst genau definiert als Lotbelag auf dem entsprechenden Lötpad aufzubringen. Nachdem das Lotdepot auf die Lötpads von mindestens einem der beiden Lötpartner aufgetragen worden ist, werden die beiden Lötpartner positionsgenau übereinander gelegt. Danach werden entsprechend dem Bügellötverfahren mit einem heißen Lötstempel die Lotdepots unter Zusammenpressen der Lötpartner aufgeschmolzen. Falls nun das Volumen des aufgetragenen Lotdepots entsprechend den prozessbedingten Schwankungen zu groß ausgefallen ist, wird das überschüssige Lot aus den Bereichen der Lötpads austreten, was zur Kurzschlussbildung zwischen den Leiterbahnen führen kann, wodurch dann der gesamte Verbund unbrauchbar ist. Die Abstände zwischen den Lötpads können deshalb nicht beliebig verringert werden.

In dem Gebrauchsmuster DE 29517067 U1 werden Leiterbahnanordnungen gezeigt, die vergrößerte Flächen zum Aufnehmen von überschüssigem Lötzinn aufweisen.

Die Reduzierung der Leiterbahnabstände für einen derartigen Verbund ist auch mit den in DE 29517067 U1 aufgezeigten Maßnahmen beschränkt, weil der Ausweichbereich für das überschüssige Lot quer zu den Leiterbahnen, also in Richtung des zu minimierenden Abstandsmaßes angeordnet ist. Darüber hinaus kann sich bei einer Ausführung gemäß DE 29517067 U1 das Lot ungehindert auf die gesamte Fläche des Lötpads verteilen, auch wenn beispielsweise das Volumen des aufgetragenen Lotdepots innerhalb der Toleranzen relativ klein ist. In diesem Fall kann für die eigentliche Kontaktfläche tendenziell zu wenig Lotmaterial vorhanden sein.

Der Erfindung liegt daher die Aufgabe zugrunde einen Verbund aus flächigen Elementen, die Leiterbahnen aufweisen zu schaffen, bei dem das Abstandsmaß zwischen den Leiterbahnen minimiert werden kann. Darüber hinaus soll auch bei geringen Abständen zwischen den einzelnen Leiterbahnen eine ausreichende Sicherheit gegen Lotbrücken erreicht, und eine gute Qualität der Lötverbindungen sichergestellt werden.

Diese Aufgabe wird durch eine Vorrichtung gemäß Anspruch 1 gelöst.

Insbesondere soll der erfindungsgemäße Verbund bei Sensorelementen verwendet werden, dies ist im Anspruch 6 angegeben.

Vorteilhafte Ausführungsformen der erfindungsgemäßen Vorrichtung beziehungsweise der erfindungsgemäßen Verwendung ergeben sich aus den Maßnahmen in den von Anspruch 1 abhängigen Ansprüchen, beziehungsweise den von Anspruch 6 abhängigen Ansprüchen.

Danach umfasst die Erfindung einen Verbund aus zwei flächigen Elementen, beispielsweise bestehend aus einem starren und einem flexiblen Trägersubstrat mit dazugehörigen Leiterschichten. Als Trägersubstrate kommen etwa Polyimidfolien, Glasplättchen oder glasfaserverstärkte Epoxydharzplatten in Betracht. Die Leiterstrukturen bestehen beispielsweise aus einer etwa 20 µm dicken Kupferschicht, die auf das elektrisch nicht leitende Trägersubstrat aufgetragen wird. Die Leiterstrukturen können entsprechend ihrer Funktion und/oder ihrer Ausgestaltung in verschiedene Teilelemente untergliedert werden.

Eines dieser Teilelemente ist das bereits oben genannte Lötpad, auf welchem die Kontaktflächen für die Lötverbindung vorgesehen sind. Die Lötpads sind üblicherweise vergleichsweise breit. Ein weiteres Teilelement ist eine Leiterbahn, die im Wesentlichen die Aufgabe hat, eine elektrische Verbindung zwischen zwei Funktionsbereichen auf ihrem Trägersubstrat herzustellen. Funktionsbereiche können alle Strukturen auf dem Trägersubstrat, zum Beispiel Lötpads oder Sensorelemente sein. Häufig sind die Leiterbahnen die schmalsten der Leiterstrukturen. Der erfindungsgemäße Verbund weist neben den beiden oben genannten Teilelementen der Leiterstruktur noch zwei weitere auf, nämlich den Lotausweichbereich und einen sogenannten Stegbereich. Die Lotausweichbereiche haben im Wesentlichen die Funktion überschüssiges Lot aufzunehmen. Die Stegbereiche stellen die Verbindung zwischen den Lötpads und den Lotausweichbereichen her.

Mit Vorteil wird der erfindungsgemäße Verbund durch das Bügellötverfahren hergestellt, wobei dasjenige Lötpad, auf welches das Lotdepot vor dem eigentliche Lötvorgang aufgetragen wird vorzugsweise kleiner ist, als das ihm gegenüberliegende. Bei einer optimal ausgeführten Verlötung entspricht das kleinere Lötpad gleichzeitig dem Kontaktbereich der Lötverbindung. Der Lotausweichbereich kann sowohl auf dem Trägersubstrat mit dem vorbeloteten Lötpad, als auch auf dem gegenüberliegenden Trägersubstrat angeordnet sein. Es ist jedoch zweckmäßig, wenn der Lotausweichbereich auf demjenigen Trägersubstrat angeordnet ist, auf welchem kein Lotdepot vor dem Lötvorgang aufgetragen wurde. Ebenso können die Stegbereiche beliebig auf einem der beiden Trägersubstrate ausgebildet sein. Die Erfindung umfasst selbstverständlich auch einen Verbund, bei dem die Lotdepots oder die Stegbereiche oder beides auf beiden Trägersubstraten angeordnet sind. Gegebenenfalls kann es auch günstig sein, wenn mehrere Lotausweichbereiche für eine Lötstelle mit einem oder mehreren Stegbereichen vorgesehen sind. Die Lötverbindungen des Verbundes sind jedoch nicht als Durchsteckkontakte ausgeführt.

Weitere Vorteile, sowie Einzelheiten des erfindungsgemäßen Verbundes und dessen Verwendung ergeben sich aus der nachfolgenden Beschreibung eines Ausführungsbeispieles anhand der beiliegenden Figuren.

Es zeigt:
- Figur 1: eine Explosionszeichnung eines Verbundes aus einer flexiblen Leiterbahn mit einer Leiterplatte;
- Figur 2: eine Draufsicht auf den Verbund, durch die flexible Leiterbahnfolie hindurch, wobei die gezeigte Leiterplatte unter anderem Sensorstrukturen aufweist;

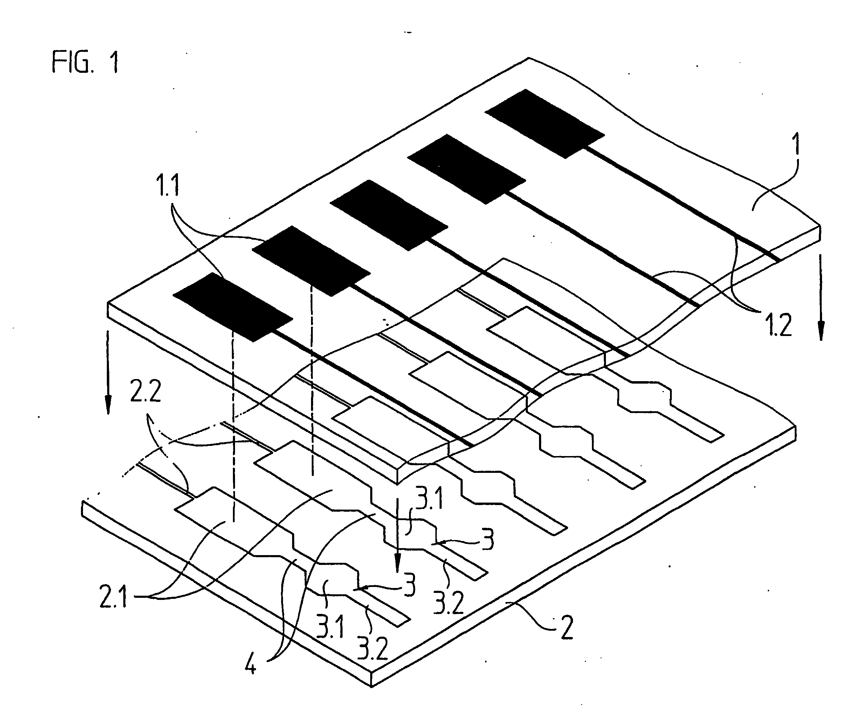

Die Figur 1 zeigt eine räumliche Darstellung eines Verbundes, die der Übersichtlichkeit halber als Explosionszeichnung ausgeführt ist. An der Unterseite einer etwa 50 µm dicken flexiblen Leiterbahnfolie 1 aus Polyimid sind Lötpads 1.1, bestehend aus einer 15 µm bis 20 µm dicken Kupferschicht angebracht. Darüber hinaus befinden sich auch auf dieser Seite der.Leiterbahnfolie 1 Leiterbahnen 1.2, die ebenfalls aus Kupfer sind und etwa die gleiche Schichtdicke aufweisen wie die Lötpads 1.1. Über die Leiterbahnen 1.2 werden elektrische Signale an eine nicht näher dargestellte Elektronik übertragen.

Der Leiterbahnfolie 1 gegenüber liegend ist eine Leiterplatte 2 aus Glas angeordnet. Auf der Leiterplatte 2 sind Lötpads 2.1, Leiterbahnen 2.2, Lotausweichbereiche 3 und Stegbereiche 4 aus Kupfer mit einer Schichtdicke von etwa 3 µm aufgetragen. Falls erforderlich wird vor dem Aufbringen der Kupferschicht ein Haftvermittler auf der Leiterplatte 2 vorgesehen. Die Stegbereiche 4 stellen eine Verbindung zu den Lotausweichbereichen 3 her. Dadurch, dass die Stegbereiche 4 schmaler sind als die Lötpads 2.1 und auch schmaler als die Lotausweichbereiche 3 ergibt sich ein Rückhalteeffekt für das flüssige Lot, das in die Lotausweichbereiche 3 gedrängt wird, sofern ein Lotüberschuss vorhanden ist. In dem gezeigten Beispiel beträgt die Breite des Stegbereiches 4 etwa 40% der Breite des Lötpads 2.1.

Die Lotausweichbereiche 3 weisen einen breiteren Abschnitt 3.1 und eine rechteckförmige Fläche 3.2 auf. Der Lotausweichbereich 3 ist so angeordnet, dass dessen breiterer Abschnitt 3.1 und dessen rechteckförmige Fläche 3.2 nach dem passgenauen Zusammenfügen der Leiterplatte 2 und der Leiterbahnfolie 1 der Leiterbahnen 1.2 gegenüberliegen.

Die Leiterbahnen 2.2 führen in diesem Beispiel zu Sensorstrukturen 5 eines Drehgebers, die in der Figur 1 nicht gezeigt sind.

Im Übrigen ist die Erfindung nicht auf Stegbereichgeometrien beschränkt, bei welcher die Stegbereiche 4 eine Rechteckform aufweisen. Beispielsweise können die Stegbereiche 4 auch derart ausgeführt sein, dass ihre Breite über ihre Länge nicht konstant ist, so dass in einem oder mehreren Bereichen eine Engstelle, die schmaler als das Lötpad 2.1 ist, vorliegt. Dadurch wird der Rückhalteeffekt im wesentlichen durch diese Engstelle oder Engstellen bewirkt. Darüber hinaus sind durch die Erfindung auch Anordnungen eingeschlossen, bei denen ein geometrisch fließender Übergang zwischen den einzelnen Teilelementen der Leiterstrukturen vorliegt. So muss nicht zwingend der Stegbereich 4 geometrisch vom Lotausweichbereich 3 abgesetzt sein, sofern eine Engstelle den erforderlichen Rückhalteeffekt ermöglicht ist diese als Stegbereich zu sehen.

Vor dem Bügellöten wird auf die Lötpads 1.1 der Leiterbahnfolie 1 ein Lötdepot, bestehend aus einer Blei-Zinn-Mischung mit einer Schichtdicke zwischen 10 µm und 20µm aufgetragen. Danach werden die Leiterplatte 2 und die Leiterbahnfolie 1 passgenau übereinander gelegt, so dass die Lötpads 1.1 und 2.1 gegenüber zu liegen kommen. Anschließend wird auf die Leiterbahnfolie 1 ein heißer Lötstempel aufgedrückt, was zur Folge hat, dass die Lotdepots zwischen der Leiterbahnfolie 1 und der Leiterplatte 2 erwärmt werden und aufschmelzen. Um eine optimale Wirkung der Lotausweichbereiche 3 zu erzielen, werden diese durch den Lötstempel miterhitzt.

Falls das Volumen des Lotdepots im unteren Toleranzbereich aufgetragen wurde, wenn also die Lotmenge effektiv vergleichsweise gering ist, wird sich das Lot im Bereich der Lötpads 1.1 bzw. 2.1 ausbreiten. Der Stegbereich 4 hat aufgrund seiner geringeren Breite einen gewissen Rückhalteeffekt gegenüber dem Lotfluss. Auf diese Weise wird bei einem kleinen Lotdepot das Lot im Kotaktbereich gehalten, so dass dieser auch unter der oben genann-ten Randbedingung optimal benetzt wird, was letztlich zu einem guten Lötergebnis führt.

Für den Fall, dass das Lotdepot ein tatsächliches Volumen aufweist, das größer ist als der Sollwert, so wird das überschüssige Lot durch den Druck des Lötstempels über den Stegbereich 4 in den Lotausweichbereich 3 gedrängt. Aufgrund der Benetzungseigenschaften der Leiterbahnfolie 1 und der Leiterplatte 2 wird das Lot nicht auf die Leiterbahnfolie 1 bzw. Leiterplatte 2 zwischen den Lötpads 1.1 bzw. 2.1 fließen, so lange der Stegbereich 4 und der Lotausweichbereich 3 noch Lot aufnehmen kann. Die Flächen des Stegbereiches 4 und des Lotausweichbereiches 3 sind so bemessen, dass das gesamte überschüssige Lot, welches im Rahmen der vorgegebenen Lotdepottoleranzen anfallen kann, aufgenommen wird.

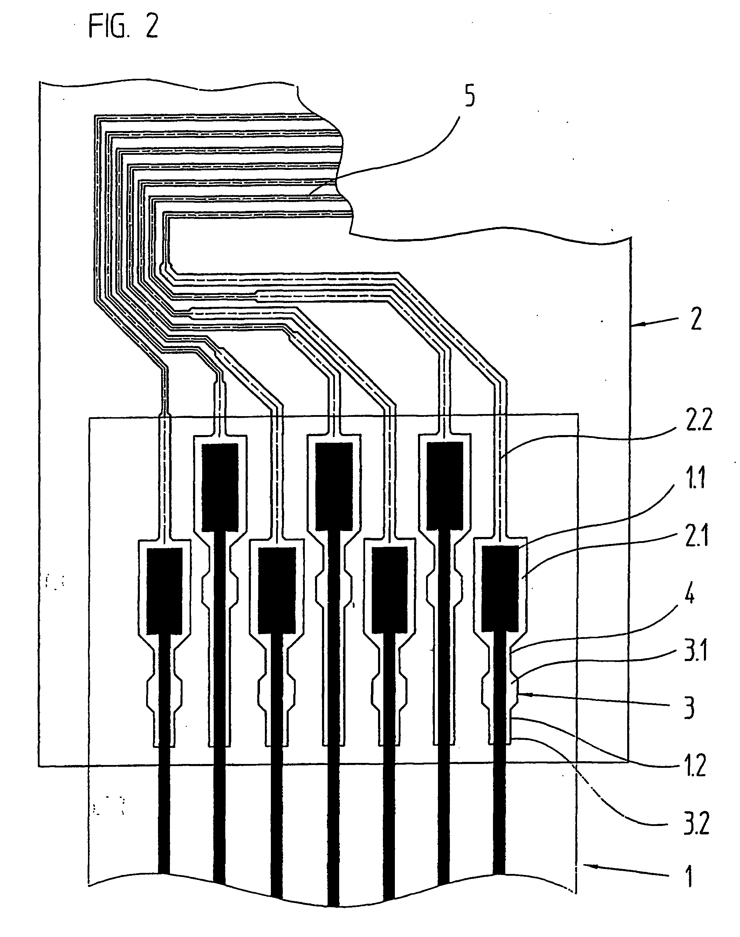

In der Figur 2 ist ein Ausschnitt aus einem erfindungsgemäßen Verbund als Durchsicht durch die Leiterbahnfolie 1 gezeigt. Auf der Leiterplatte 2 sind magneto-resistive Sensorstrukturen 5 aus einer Nickel-Eisen-Legierung aufgebracht, wie sie beispielsweise bei Drehgebem oder Längenmessgeräten verwendet werden. In diesen Anwendungen wird eine Relativposition durch Abtasten von magnetisierten Teilungstrommeln oder -maßstäben bestimmt.

Im gezeigten Ausführungsbeispiel sind die Leiterbahnen 1.2 auf der Leiterbahnfolie 1, derart angeordnet, dass nach dem ordnungsgemäßen Zusammenfügen der Leiterbahnfolie 1 mit der Leiterplatte 2 die Leiterbahnen 1.2 über den Lotausweichbereichen 3 und den Stegbereichen 4 zu liegen kommen. Die Leiterbahnen 1.2 weisen also die gleiche Verlaufsrichtung auf, wie die Stegbereiche 4 und die Lotausweichbereiche 3 und haben überdies bezüglich ihres Abstandes das gleiche Teilungsmaß wie die Stegbereiche 4 beziehungsweise die Lotausweichbereiche 3. Diese Gestaltung hat den Vorteil, dass auch der Stegbereich 4 und der Lotausweichbereich 3 in elektrischen Kontakt außerhalb der Lötpads 1.1 und 2.1 mit der Leiterbahn 1.2 steht, wenn das Lot in den Stegbereich 4 und gegebenenfalls darüber hinaus auch in den Lötausweichbereich 3 abfließt. Auf diese Weise wird die Kontaktsicherheit weiter erhöht.

Die Leiterbahnen 1.2 auf der flexiblen Leiterbahnfolie 1 führen zu einer in der Figur 2 nicht dargestellten Auswerteelektronik am anderen Ende der Leiterbahnfolie 1. Das in der Figur 2 nicht gezeigte andere Ende der Leiterbahnfolie 1 wird mit einer Platine der Auswerteelektronik zur Verarbeitung der Messsignale in Kontakt gebracht. Auch dort kann mit Vorteil durch eine Lötverbindung ein erfindungsgemäßer Verbund hergestellt werden. Altemativ zur Verwendung einer Lötverbindung an jener Stelle kann die Auswerteelektronik auch durch einen Stecker mit der Leiterbahnfolie 1 verbunden werden.

Selbstverständlich ist die Erfindung nicht auf die Ausführungsform des oben vorgestellten Beispieles beschränkt. So können gegebenenfalls auch drei flächige Leiterplatten oder Leiterbahnfolien miteinander verlötet werden, wobei eines dieser flächigen Elemente beispielsweise nach Art eines Sandwich-Aufbaues zwischen den beiden anderen angeordnet ist.

## Patentansprüche

1. Verbund aus mindestens zwei flächigen Elementen, bestehend aus einem ersten und einem zweiten Trägersubstrat (1;2), auf welchen Leiterstrukturen (1.1; 1.2; 2.1; 2.2; 3; 4) aufgebracht sind, wobei zumindest ein Lötpad (1.1) des ersten Trägersubstrates (1) mit zumindest einem Lötpad (2.1) des zweiten Trägersubstrates (2) verlötet ist, und mit zumindest einem Stegbereich (4), der mindestens einen Lotausweichbereich (3) mit mindestens einem Lötpad (1.1; 2.1) verbindet, wobei der Stegbereich (4) schmaler ist als eines der mit ihm verbundenen Lötpads (1.1; 2.1) und Lotausweichbereiche (3), und mindestens eine Lötstelle, bestehend aus Lötpad (1.1; 2.1), Stegbereich (4) und Lotausweichbereich (3), vollständig zwischen den beiden Trägersubstraten (1;2) liegt, so dass dem Lotausweichbereich (3) auf dem zweiten Trägersubstrat (2) eine Leiterbahn (1,2) auf dem ersten Trägersubstrat (1) gegenüberliegt.

2. Verbund nach Anspruch 1, **dadurch gekennzeichnet, dass** zumindest ein Trägersubstrat (1;2) flexibel ist.

3. Verbund nach einem der Ansprüche 1 oder 2, **dadurch gekennzeichnet, dass** ein Trägersubstrat (1;2) aus einer starren Platte, insbesondere einer Glasplatte besteht.

4. Verbund nach einem der Ansprüche 1 bis 3, **dadurch gekennzeichnet, dass** mindestens ein Lotausweichbereich (3) auf dem Trägersubstrat (1;2) vorgesehen ist, auf welchem vor dem Verlöten kein Lot aufgetragen wurde.

5. Verbund nach einem der Ansprüche 1 bis 4, **dadurch gekennzeichnet, dass** das Lötpad (1.1) des ersten Trägersubstrates (1) größer ist als dasjenige des zweiten.

6. Verwendung des Verbundes nach einem der vorhergehenden Ansprüche in einem Sensorelement.

7. Verwendung gemäß Anspruch 6, **dadurch gekennzeichnet, dass** das Sensorelement Bestandteil einer Positionsmesseinrichtung ist.

## Claims

1. Composite made of at least two planar elements, comprising a first and a second carrier substrate (1; 2) on which conductive structures (1.1; 1.2; 2.1; 2.2; 3; 4) are applied, at least one solder pad (1.1) of the first carrier substrate (1) being soldered to at least one solder pad (2.1) of the second carrier substrate (2), and with at least one web region (4), which connects at least one solder escape region (3) to at least one solder pad (1.1; 2.1), the web region (4) being narrower than one of the solder pads (1.1; 2.1) and solder escape regions (3) which are connected to it, and at least one soldering joint comprising solder pad (1.1; 2.1), web region (4) and solder escape region (3) being situated entirely between the two carrier substrates (1; 2), so that a conductive path (1.2) on the first carrier substrate (1) is situated opposite the solder escape region (3) on the second carrier substrate (2).

2. Composite according to claim 1, **characterised in that** at least one carrier substrate (1; 2) is flexible.

3. Composite according to one of the claims 1 or 2, **characterised in that** one carrier substrate (1; 2) comprises a rigid plate, in particular a glass plate.

4. Composite according to one of the claims 1 to 3, **characterised in that** at least one solder escape region (3) is provided on the carrier substrate (1; 2), on which no solder has been applied prior to soldering.

5. Composite according to one of the claims 1 to 4, **characterised in that** the solder pad (1.1) of the first carrier substrate (1) is larger than that of the second.

6. Use of the composite according to one of the preceding claims in a sensor element.

7. Use according to claim 6, **characterised in that** the sensor element is a component of a position measuring device.

## Revendications

1. Composite formé d'au moins deux éléments plats constitués par un premier et un second substrat porteur (1 ; 2) sur lesquels sont déposées des structures conductrices (1.1 ; 1.2 ; 2.1 ; 2.2 ; 3 ; 4). composant dans lequel :
- au moins une portée à braser (1.1) du premier substrat porteur ( 1) est reliée par brasage à au moins une portée à braser (2.1) du second substrat porteur (2)
- au moins une zone en forme de barrette (4), qui relie au moins une zone d'expansion de brasure (3) à au moins une portée à braser (1.1 ; 2.1) est plus étroite qu'une des portées à braser (1.1 ; 2.1) et des zones d'expansion de brasure (3)
- au moins un joint brasé constitué de la portée à braser (1.1 ; 2.1) de la zone en forme, de barrette (4) et de la zone d'expansion de brasure (3) se trouve entièrement entre les deux substrats porteurs (1 ; 2) de sorte que la zone d'expansion de brasure (3) située sur le second substrat porteur (2) se trouve en face d'une piste conductrice (1.2) située sur le premier substrat porteur.

2. Composite selon la revendication 1, **caractérisé en ce qu'**un substrat porteur (1 ; 2) est flexible.

3. Composite selon la revendication 1 ou 2, **caractérisé en ce qu'**un substrat porteur (1 ; 2) est constitué par une plaque rigide en particulier une plaque en verre.

4. Composite selon une des revendications 1 à 3, **caractérisé en ce qu'**au moins une zone d'expansion de brasure (3) est prévue sur le substrat porteur (1.2) sur lequel aucune brasure n'a été déposée avant le brasage.

5. Composite selon une des revendications 1 à 4, **caractérisé en ce que** la portée à braser (1.1) du premier substrat porteur (1) est plus grande que la portée à braser du second substrat porteur.

6. Utilisation dans un élément capteur du composite selon une des revendications précédentes.

7. Utilisation selon la revendication 6, **caractérisée en ce que** l'élément capteur est un composant d'un dispositif de mesure de position.
